# EUROPEAN PATENT APPLICATION

(11) **EP 1 189 111 A1**
(43) Date of publication of application: **20.03.2002**
(21) Application number: 00919134.7
(22) Date of filing: 18.04.2000
(51) Int. Cl.: G03F 7/20, G03F 1/08

(54) **PRODUCTION DEVICE FOR PRINTED BOARD, PRODUCTION METHOD FOR PRINTED BOARD AND PRINTED BOARD**

(30) Priority: 27.05.1999 JP 14857999
(71) Applicant: Kem-Tec Japan Co., Ltd, Utsunomiya-shi, Tochigi 321-0137 (JP)
(72) Inventor: KARAMATSU, Hamataro, Nara-shi, Nara 631-0033 (JP)
(74) Representative: Luderschmidt, Schüler & Partner GbR
(86) International application number: JP0002519
(87) International publication number: WO0073855

(57) **Abstract**

The object is to provide a printed board manufacturing apparatus, printed board manufacturing method and a printed board produced thereby, in which stepwise exposures of an original photomask can be performed with an improved production yield by taking into account identification markings. In a stepwise exposure apparatus 'A' for performing the exposure step for a printed board substrate (2) in which an original mask (3) having an wiring pattern area (3a) and identification marking areas (3c1) to (3c3) around the wiring pattern area (3a) is exposed stepwise a plurality of times to the printed board substrate (2) while shifting successively the site to be exposed, original mask (3) is arranged to face the printed board substrate (2) surface to be exposed; an opaque masking element (4) is disposed on one side of the original mask (3) on the other side of which disposed is the printed board substrate (2); and the opaque masking element (4) selectively masks identification marking areas (3c1) to (3c3) of the original mask (3).

## Description

### Technical Field

The present invention relates to a manufacturing apparatus for printed wiring boards, a manufacturing method of printed wiring boards and the printed wiring board produced by the method wherein the production process of printed wiring boards is implemented by stepwise exposure.

### Background Art

Conventionally, as the means of circuit formation for a printed wiring board (to be referred to hereinbelow as 'printed board'), the printing technique using ink and the photographic technique by light exposure have been generally known. Of these, the photographic technique has been often used for fabrication of a small number of printed boards with a high precision and high density pattern.

The fabrication of printed boards by the photographic technique is carried out by projecting a photoresist pattern (to be referred to hereinbelow as 'wiring pattern') of an original photomask onto the photo-sensitive surface using exposure equipment and creating a conductive coating pattern on the printed board using photographic etching or other processes. More specifically, the substrate to be formed into a printed board is made up of an insulating substrate coated on the surface thereof by a conductive film. A photoresist layer is formed on the surface of this conductive film by spraying a liquid photo-sensitive material thereon and drying it or by applying a photo-sensitive thin film over the surface. Then, an original photomask or wiring pattern formed on a glass plate, film or the like is projected onto the photoresist surface of the printed board using a projection exposure apparatus. After exposure the exposed photoresist is developed and the same (or enlarged or reduced) wiring pattern as that of the photomask is formed. Thereafter, this wiring pattern serves as a mask so as to etch the conducting layer to obtain a printed board with the desired conductive layer pattern.

In this case, it is preferred from a productivity viewpoint that the work size of the substrate or the like for forming a printed board is as large as possible and a plurality of wiring patterns and the like are exposed at a time using a large original photomask in conformity with the size of the printed board.

On the other hand, since printed boards and original photomasks made up of glass, film or the like expand or contract being affected by temperature and humidity, it is preferred that the work size is as small as possible in order to achieve exposure with a higher precision.

With the above reason, a stepwise exposure technique or a method in which a large-sized work is sequentially exposed step by step by scanning a small original photomask has been attempted.

When a large work is sequentially exposed with small wiring patterns, it is preferred from a viewpoint of improving the productivity that the wiring pattern interval be as small as possible or that adjacent wiring patterns be exposed with a narrow margin.

Each small-sized original photomask has identification marking such as user name, item number, etc., formed at the periphery of its wiring pattern to identify the wiring pattern.

Therefore, in the stepwise exposure technique or the method in which a large-sized work is sequentially exposed a plurality of times by scanning a small original photomask, the interval between adjacent wiring patterns becomes large because the margin including the identification marking space is formed for every exposure. This results in a poor fabrication yield. This is why this method has not been put into practice up to now.

The present invention has been devised to solve the above problems, it is therefore an object of the present invention to provide a manufacturing apparatus for printed boards, a manufacturing method of printed wiring boards and the printed wiring board produced by the method, whereby stepwise exposure of an original photomask can be achievedwith a high fabrication yield by taking into account identification marking.

### Disclosure of Invention

In order to solve the above problems, the present invention has the following configurations.

The first aspect of the present invention resides in a printed board manufacturing apparatus wherein, in the exposure step for a printed board substrate, the printed board substrate is exposed stepwise a plurality of times through an original mask having a wiring pattern area and an identification marking area around the wiring pattern area while shifting successively one after another position to be exposed, characterized in that the original mask is arranged to face the printed board substrate surface to be exposed; an opaque masking element is disposed on one side of the original mark on the other side of which disposed is the printed board substrate; and the opaque masking element selectively masks the identification marking area of the original mask.

The second aspect of the present invention resides in the printed board manufacturing apparatus having the above first aspect and characterized in that the opaque masking element is a masking plate which is able to selectively mask the identification marking area on the original mask in association with the position to be exposed of the printed board substrate.

The third aspect of the present invention resides in the printed board manufacturing apparatus having the above first aspect and characterized in that the opaque masking element is configured of a liquid crystal panel which is able to selectively mask the identification marking area on the original mask in association with the position to be exposed of the printed board substrate.

The fourth aspect of the present invention resides in a printed board manufacturing method wherein, in the exposure step for a printed board substrate, the printed board substrate is exposed stepwise a plurality of times through an original mask having a wiring pattern area and an identification marking area around the wiring pattern area while shifting successively one after another position to be exposed, characterized in that a plurality of exposures are performed by masking the identification marking area so that no identification making area will be exposed between adjacent wiring pattern areas to be exposed.

The fifth aspect of the present invention resides in a printed board produced by the printed board manufacturing method defined by the above fourth aspect.

According to the above configurations, the effects as follows can be obtained.

According to the first aspect of the present invention, the arrangement of the original mask facing the printed board substrate surface to be exposed makes it possible for the printed board substrate to be exposed through the wiring pattern in the wiring pattern area and the identification marking in the identification marking area on the original mask. Further, since arrangement of the opaque masking element disposed on one side of the original mask on the other side of which disposed is the printed board substrate makes it possible to block irradiation, it is possible to avoid exposure of the original mask by that blocked part only.

Further, since the opaque masking element selectively masks the identification marking area of the original mask, it is possible to expose the wiring patterns with a narrow spacing therebetween to the printed board substrate, so that the number of wiring patterns to be exposed in a predetermined size can be increased, leading to improvement in production yield and productivity.

It is possible to provide the identification marking necessary for production process management by selectively exposing the identification marking area in the area around the wiring pattern, i.e., the periphery of the printed board where no improvement in production yield can be expected, or in the spacings between adjoining wiring patterns where no improvement in production yield is expected even when the spacing between the adjacent wiring patterns is made narrow. Further, since wide margins can be formed at the areas close to the periphery of the printed board substrate, it is possible to secure the plating lead space for the printed board substrate, hence improve the plating process efficiency.

According to the second aspect of the present invention, since the masking plate is able to selectively mask the identification marking area on the original mask in association with the exposed position on the printed board substrate, it is possible to configure a masking element as a simple device.

According to the third aspect of the present invention, since the masking element is configured of the liquid crystal panel, the identification marking area on the original mask can be selectively masked by electrically switching the black and white areas in the liquid crystal panel without using any mechanically moving part. Further, since the liquid crystal panel has a thin outer dimension and is light-weighted, it is possible to provide a compact printed board manufacturing apparatus.

According to the fourth aspect of the present invention, since a plurality of exposures are performed by masking the identification marking area so that no identification marking area will be exposed between adjacent wiring patterns to be exposed, the spacing between adjacent wiring patterns to be exposed can be controlled so that it is possible to optimally expose as many wiring patterns as possible in a printed board substrate of a predetermined size.

Further, the identification marking area can be exposed on the area where no wiring patterns are put adjacent to each other or the peripheral part of the printed board substrate.

Accordingly, it is possible to improve the production yield and productivity for a printed board substrate of a predetermined size as well as to provide the identification marking necessary for production process management.

According to the fifth aspect of the present invention, since exposure of wiring patterns on the printed board substrate is sequentially performed stepwise, it is possible to create high-precision wiring patterns by suppressing influences such as thermal contraction of the printed board substrate and the original mask to a high degree.

Since the spacing between adjacent wiring patterns to be exposed can be adjusted, it is possible to optimally expose as many wiring patterns as possible in a printed board substrate of a predetermined size. Therefore, it is possible to improve the production yield and productivity.

Since it is possible to expose the identification marking area at the peripheral part of the printed board substrate, it is possible to create the identification marking necessary for production process management. Since wide margins can be formed at the peripheral part and the like of the printed board substrate, it is possible to secure the plating lead space for the printed board substrate, so improve the plating process efficiency.

### Brief Description of Drawings

Fig.1 is a partly block-diagram schematic illustrative view of a printed board manufacturing apparatus for implementing stepwise exposure according to the first embodiment of the present invention;
Fig.2 is a partly enlarged operational diagram for illustrating a printed board manufacturing apparatus for implementing stepwise exposure according to the first embodiment of the present invention;
Fig. 3 shows front views (a, b) of an area mask and pattern mask according to the first embodiment of the present invention and an operational diagram for illustrating their positional relationship (c) upon exposure;
Fig.4 is an operational diagram illustrating an area mask according to the first embodiment of the present invention;
Fig.5 is an illustrative view showing the geometry of four wiring patterns printed on a printed board substrate of a predetermined size in accordance with the first embodiment of the present invention;
Fig.6 is an illustrative view showing the positional relationships of a pattern mask relative to the area mask when a wiring pattern is printed at each position shown in Fig.5;
Fig.7 is an operational front view schematically illustrating an area mask according to the second embodiment of the present invention;
Fig. 8 is an illustrative view showing exposure positions of wiring patterns on a printed board substrate in accordance with the second embodiment of the present invention;
Fig.9 is an operational illustrative view showing stepwise exposures in accordance with the second embodiment of the present invention;
Fig.10 is an operational illustrative view showing stepwise exposures in accordance with the second embodiment of the present invention; and
Fig.11 is an operational illustrative view showing stepwise exposures in accordance with the second embodiment of the present invention.

### Best Mode for Carrying Out the Invention

The embodiments of the present invention will be described hereinbelow with reference to the drawings.

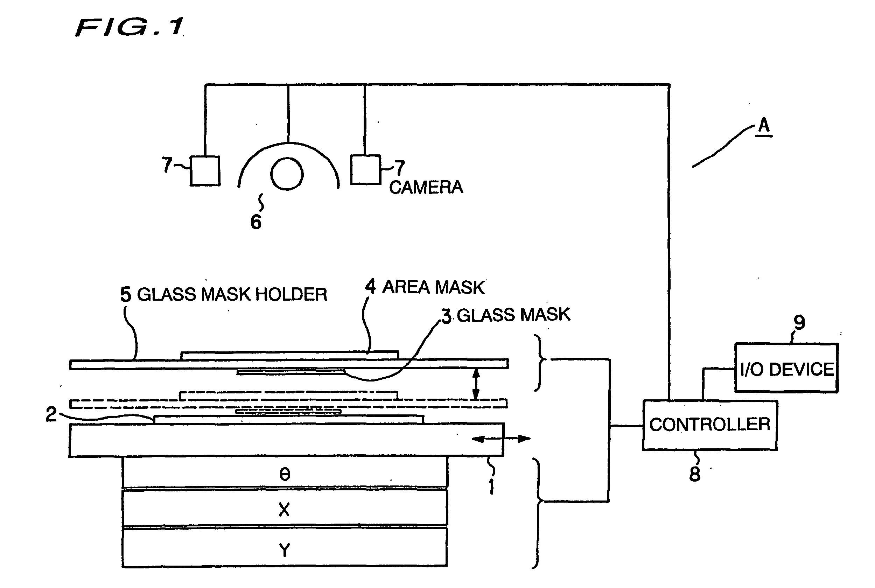

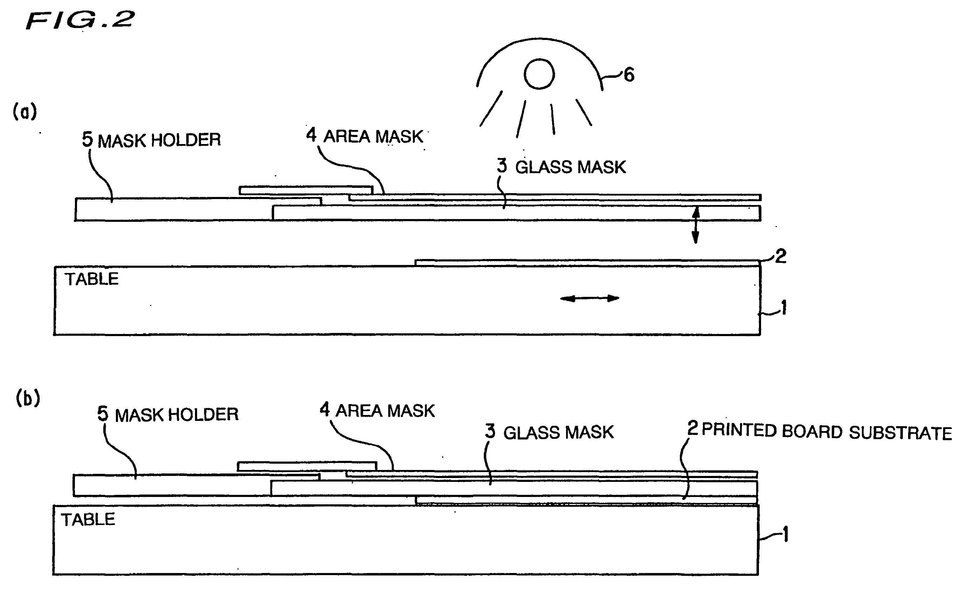

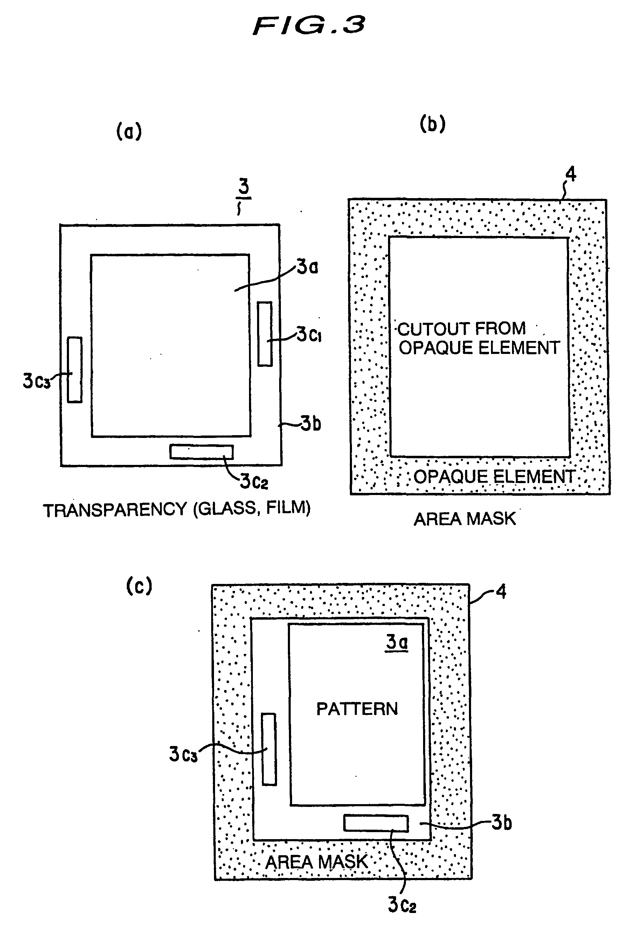

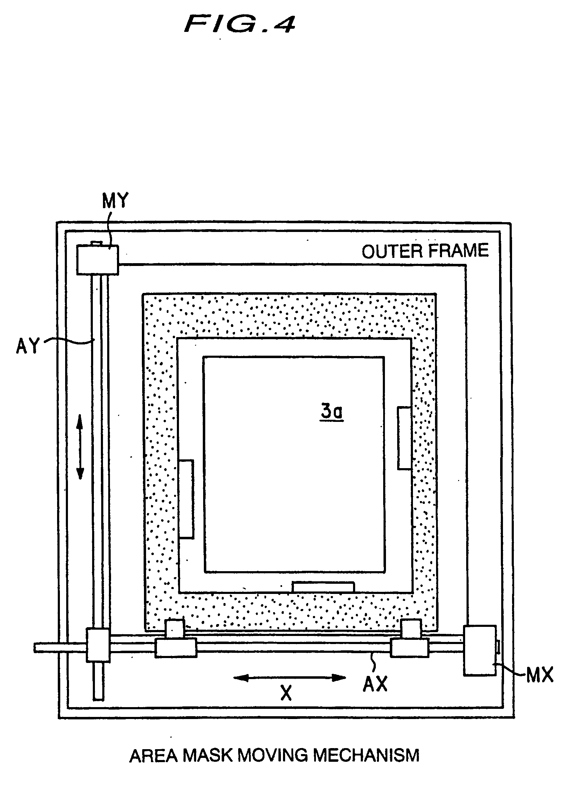

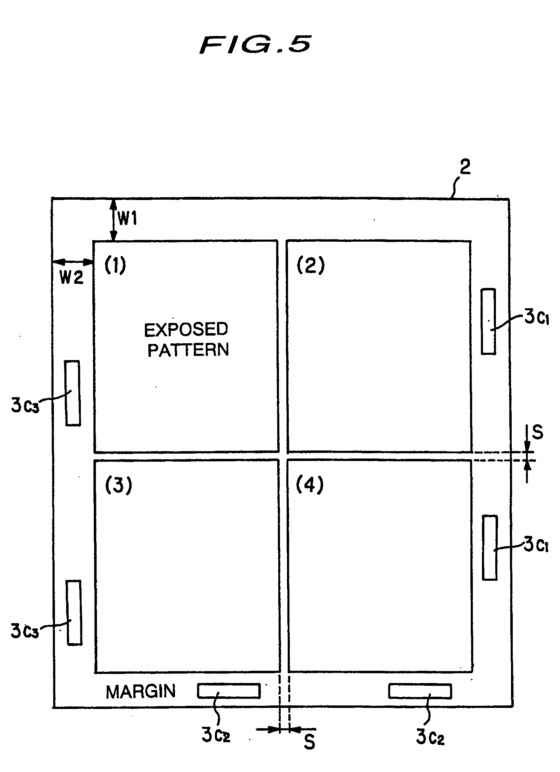

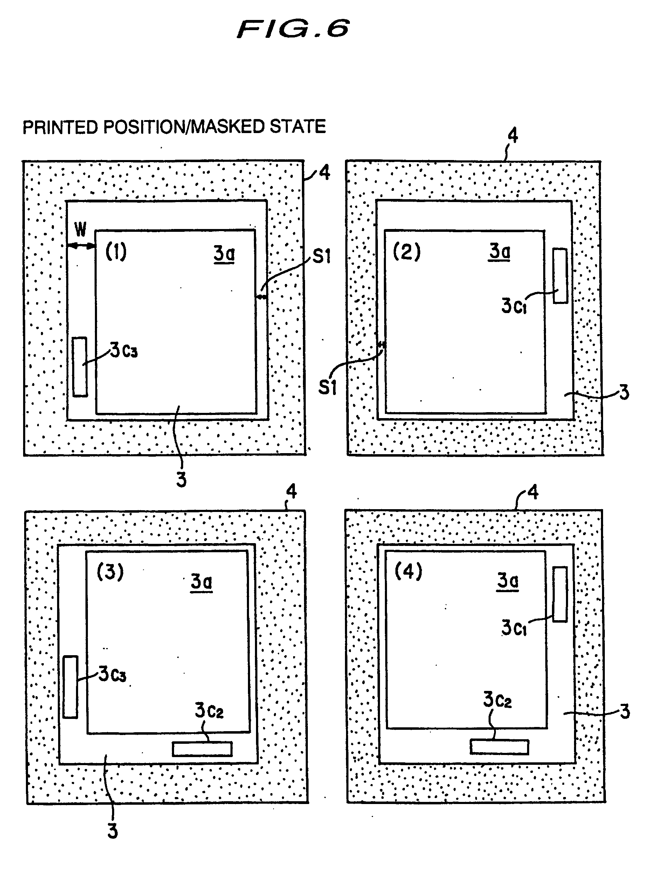

Figs. 1 to 6 illustrate the first embodiment of the present invention. Fig.1 is a schematic front view of a printed board exposure apparatus; Figs.2(a) and (b) are schematic side views showing a manufacturing apparatus (exposure step) for a printed board substrate 2 for explaining the operation of its vertical movement; Fig.3 shows front views (a, b) of an area mask 4 and pattern mask 3 and an operational diagram for illustrating their positional relationship (c) upon exposure; Fig.4 is an operational diagram of an area mask 4; Fig.5 is an illustrative view showing the geometry of four wiring patterns printed by exposure on a printed board substrate 2 of a predetermined size; and Fig.6 is an illustrative view showing the positional relationships of a pattern mask 3 relative to the area mask 4 when a wiring pattern 3a is printed by exposure at each position shown in Fig.5.

In the manufacturing apparatus (exposure step) A for printed boards shown in Fig.1, 1 designates a two-dimensionally movable table 1, 2 designates a printed board substrate 2 to be processed, 3 designates a glass mask 3 for creating a wiring pattern on printed board substrate 2, 4 designates an area mask 4 for masking glass mask 3, 5 designates a mask holder 5 as an holding element for holding glass mask 3, 6 designates a light source 6, 7 designates cameras for positioning, 8 designates a controller for controlling table 1, mask holder 5, etc., and 9 designates an input/output device for implementing input and output of data.

In Fig.1, glass mask 3, area mask 4 and mask holder 5 can be controlled by an unillustrated support means so that they can move up and down above printed board substrate 2, as is shown by a solid line and a chain line (imaginary drawing). When printed board substrate 2 and glass mask 3 and others are positioned at their predetermined locations, they are exposed to light from above or light source 6.

The aforementioned table 1 is a flat-topped table which can have printed board substrate 2 put thereon and can be controlled so as to move forwards and backwards, leftwards and rightwards and rotatably, two-dimensionally (on a plane).

Printed board substrate 2 is formed of an insulating substrate material onto which a conductive material layer is rolled or electrolytically deposited. For the insulating base material, paper, cloth, glass cloth, non-woven glass cloth, synthetic fiber cloth or the like may be used. For the conductive material layer, copper foil or the like may be used.

Though not illustrated, a photoresist layer is formed on the conductive material layer by applying and drying a liquid photo-sensitive agent, by applying a photo-sensitive thin film or the like.

As shown in Fig.3(a), glass mask 3 is comprised of a rectangular glass plate having a predetermined size with a negative(or positive) wiring pattern 3a(depicted as an area) printed in the substantially central portion and transparent marginal portion 3b arranged around it. In this transparent marginal portion 3b, identification markings 3c1, 3c2 and 3c3 (depicted with areas) such as user name, item number, lot number, etc., of the wiring pattern are printed in the left and right and bottom margins. If in the case that a positive pattern is used, transparent identification markings are formed with voids in the black margin.

Glass mask 3 is then supported at its transparent marginal portion 3b by mask holder 5 as shown in Figs. 1 and 2 and arranged so as to face, and move close to and away from, the conductive material layer of printed board substrate 2.

Area mask 4 is an opaque, frame-like plate element with its center cut out rectangularly, as shown in Fig.3(b). The cutout shape is greater in size than the wiring pattern area 3a of the glass mask 3, as shown in Fig.3(c).

As shown in Fig.2, area mask 4 is arranged a predetermined distance away from glass mask 3 on the side opposite to printed board substrate 2 side. That is, area mask 4, glass mask 3 and printed board substrate 2 are arranged in layers.

As shown in Fig.4, area mask 4 is supported by motors MX and MY and support arms AX and AY so that it can move in the X and Y directions relative to glass mask 3.

Light source 6 is arranged a predetermined distance away from the area mask 4 and emits visual light, UV light, electric beams or the like, which transmits through the wiring pattern portion of glass mask 3 to project the wiring pattern onto the photoresist layer of printed board substrate 2.

Cameras 7 are, for example, CCD cameras having photoelectric conversion device and connected to controller 8 to adjust wiring pattern 3a of glass mask 3 at an arbitrary position relative to printed board substrate 2.

Controller 8 makes the total control of exposure apparatus A and enables exposure of area mask 4 onto an arbitrary position on printed board substrate 2 based on the data from the aforementioned cameras 7 and from an aftermentioned input/output device and the like.

Examples of input/output device 9 include a keyboard, media drivers for reading data storage media such as floppy disks and hard disks, unillustrated sensors, communication media and the like, and these function as the positioning control data source for controller 8.

Next, the procedure of stepwise exposure of printed board substrate 2 through wiring pattern 3a will be described. In this embodiment, four wiring patterns 3a are printed by exposure on a printed board substrate 2 of a predetermined size, as shown in Fig.5.

Stepwise exposure is implemented in the order from (1) to (4) in Fig.5, so that all the intervals between adjacent patterns on printed board substrate 2 are set at a predetermined width S and four wiring patterns 3a are uniformly laid out in approximately the center of printed board substrate 2.

Margin widths W1 and W2 denote the distance from the edge of printed board substrate 2 after stepwise exposure to each wiring pattern 3a border. The aforementioned width S is determined arbitrarily taking into account cutting and other factors at the shape finishing stage, but may be determined automatically in accordance with the size of printed board substrate 2 and the size of wiring pattern 3a.

To begin with, in order to expose printed board substrate 2 at the area (1) in Fig.5, controller 8 controls table 1 based on the data from cameras 7 and input/output device 9 so as to determine the position of printed board substrate 2 relative to light source 6 (Fig.1) and glass mask 3 while also adjusting the positional relationship between glass mask 3 and area mask 4.

The positional relation between glass mask 3 and area mask 4 is determined as shown in Fig.6 (1) so that the margin on a side next to a neighboring wiring pattern 3a has a width S1 while, resultantly, the margins other than that next to a neighboring wiring pattern 3a have a greater width W.

After completion of the positioning, glass mask 3 and area mask 4 are controlled to move down so that glass mask 3 is put on, or placed close to printed board substrate 2 from the positions (a) to (b) in Fig.2. Then, glass mask 3 is illuminated with light from light source 6 so as to expose printed board substrate 2 surface through wiring pattern 3a.

After completion of exposure to the area (1) in Fig.5, glass mask 3 and area mask 4 are moved up and printed board substrate 2, glass mask 3 and area mask 4 are positioned in order to implement exposure of area (2) in Fig.5. For the positioning also in this case, as shown in Fig.6 (2), the margin on a side next to a neighboring wiring pattern 3a has the width S1 while the margins other than that next to a neighboring wiring pattern 3a have the greater width. The areas (3) and (4) in Fig.5 are formed in the same manner as shown in (3) and (4) of Fig.6, therefore the description is omitted.

Thus, adjacent wiring patterns 3a arrayed with a narrow spacing S from one to another as shown in Fig.5 are exposed uniformly on printed board substrate 2 by stepwise exposure four times while identification markings 3c1, 3c2 and 3c3(shown by areas) are printed in the margins (having widths W1 and W2) along the edges.

Since printed board substrate 2 is sequentially exposed through wiring patterns 3a by stepwise exposure using exposure apparatus A, it is possible to create high-precision wiring patterns by suppressing influences such as thermal contraction of printed board substrate 2 and area mask 4 to a high degree. Since adjoining wiring patterns can be exposed with narrow spacing S, it is possible to create as large a number of wiring patterns as possible on one printed board substrate, thus leading to improvement in production yield.

Further, identification markings 3c1, 3c2 and 3c3 necessary for identifying the wiring patterns such as user name, item number and lot number can be also printed on printed board substrate 2.

Since marginal spaces (widths W1 and W2) can be taken as appropriate, it is possible to secure the plating lead space (for the holding portion during plating) on printed board substrate 2 so improve the plating process efficiency. For example, if no or less area is allotted for the marginal spaces (widths W1 and W2), part of wiring patterns 3a cannot be plated because the holding member needs to hold part of wiring patterns during plating. Alternatively, complicated handling might be needed to locate areas for the holding portion where no plating is needed and to position the holding member exactly. In contrast, in the present embodiment, there is no need for complicated processes and handling mentioned above because marginal spaces (widths W1 and W2) can be secured as appropriate.

In the above first embodiment, for description convenience, the case in which four wiring patterns are formed on printed board substrate 2 was described, and in order to form simply and allow a great number of the exposures of the identification mark, frame-shaped area mask was described. However, if a greater number of wiring patterns are attempted to be formed on a single printed board, it is necessary to more specifically limit the exposures of identification markings. Therefore, a more general means for exposing wiring patterns will be described in the second embodiment.

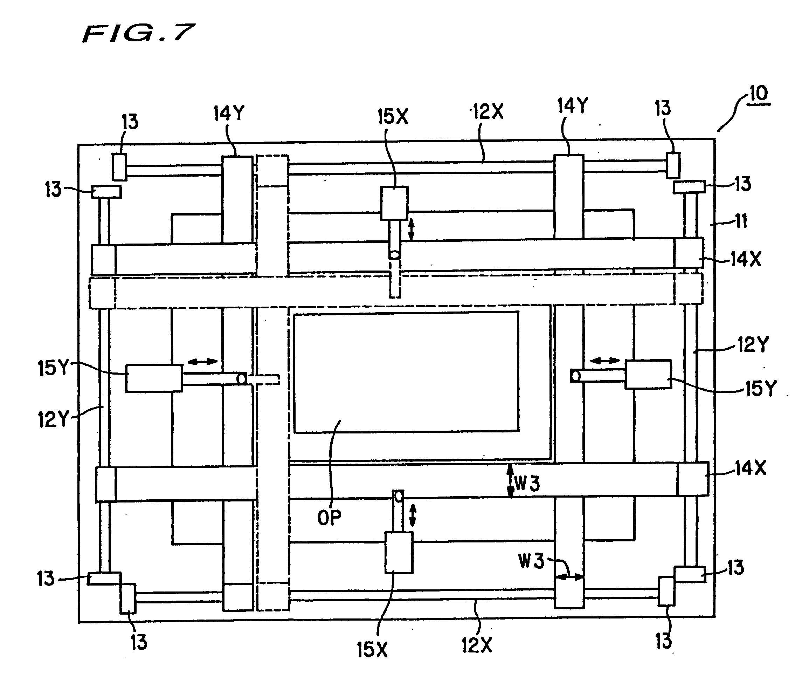

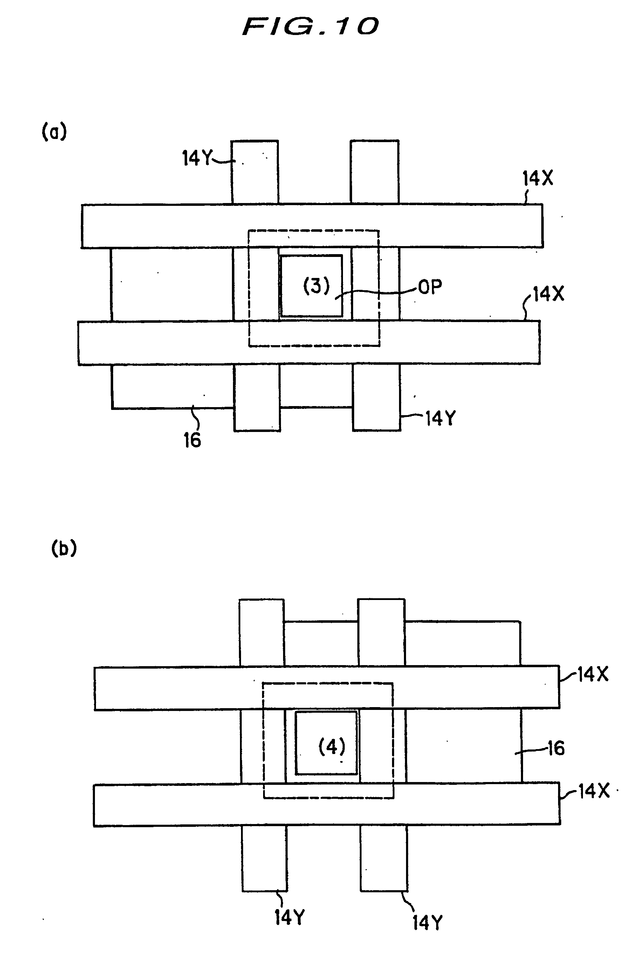

In the second embodiment, referring to Figs.7 to 11, a case where six wiring patterns are formed on a single printed board substrate by stepwise exposure will be described. Since this embodiment is the same configuration as the first embodiment except in the area mask configuration and size of the printed board substrate, the same components as in the above embodiment will be allotted with the same reference numerals without description so that mainly the features of this embodiment will be described.

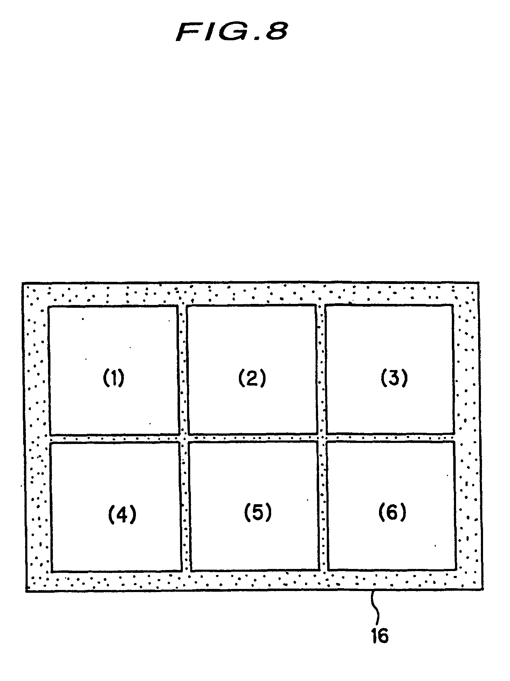

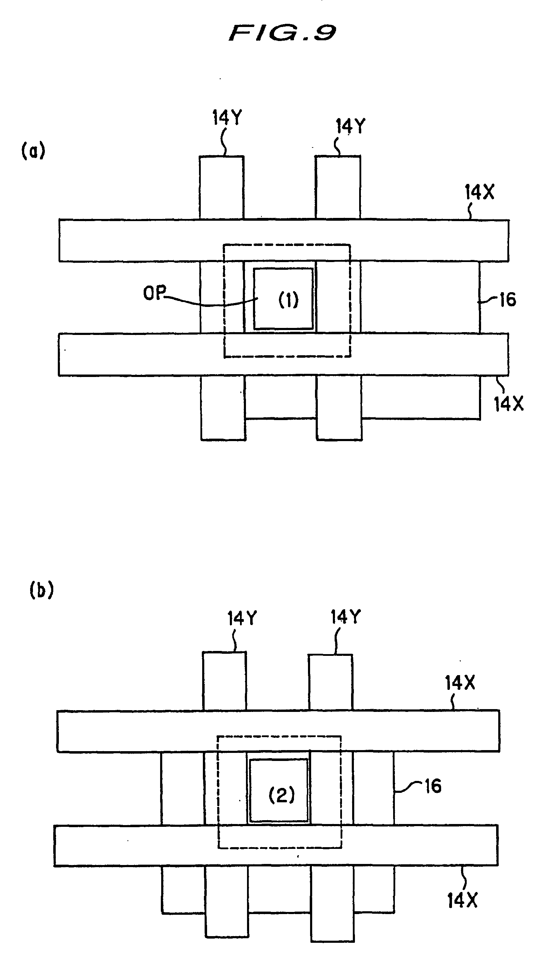

Fig.7 is an operational schematic front view of an area mask 10, Fig.8 is an illustrative view for exposure positions of wiring patterns on a printed board substrate 16, Figs.9 to 11 are operational illustrations showing stepwise exposure.

Area mask 10 shown in Fig.7 is generally comprised of a rectangular annular base 11, pairs of support arms 12X and 12Y arranged so as to be rectangular to one another along the periphery of the annular base 11, arm support members 13 for supporting the edges of support arms 12X and 12Y at predetermined heights from annular base 11, movable masks 14X and 14Y each having a width W3 and bridged at the ends between parallel support arms 12X-12X or between support arms 12Y-12Y so as to slide thereon and air cylinders 15X and 15Y for position control of the movable masks 14X and 14Y and to move back and forth. Air cylinders 15X and 15Y are position controlled by the aforementioned controller 8.

A pair of support arms 12X arranged in parallel are rod elements having the same diameter and supported at the same height over annular base 11 by arm support members 13. A pair of parallel support arms 12Y is also configured in the same manner. Support arms 12X and support arms 12Y are arranged perpendicularly to each other while support arms 12Y are supported at a level from annular base 11 higher than support arms 12X.

A pair of movable masks 14X are slidably engaged at both ends on and between the pair of support arms 12Y. Similarly, a pair of movable masks 14Y are also slidably engaged at both ends on and between the pair of support arms 12X. That is, movable masks 14X and 14Y are arranged curb-like from the front so that when each of movable masks 14X and 14Y moves, the size and position of the opening OP enclosed thereby can be varied.

With the thus constructed area mask 10, movable masks 14X and 14Y, having the predetermined width W3 and being arranged between glass mask 3 and light source 6, function to mask the light radiated from light source 6 and allow the opening OP to be adjusted in size and position by the back-and-forth control of air cylinders 15X and 15Y which are position controllable, thus providing a more generally applicable masking element.

The air cylinders 15X and 15Y are not a requirement, but any mechanism such as pulse motors, servomotors, etc., can be used as long as it can be controlled to drive the associated parts forward and backward.

Fig.8 shows a case where six wiring patterns 3a (Fig.3) are exposed on a single printed board substrate 16, and Figs.9 to 11 schematically show relative movements of area mask 10 (Fig.7) to printed board substrate 16 for exposure at different positions of wiring patterns 3a.

Also in this embodiment, adjacent wiring patterns 3a are arranged with spacing S while wide margins are provided around the periphery of printed board substrate 16.

Since the way the margins are formed when the wiring patterns 3a designated at (1), (3), (4) and (6) in Fig.8 are exposed is the same as that of the first embodiment, air cylinders 15X and 15Y are controlled so that the size of opening OP, its position relative to glass mask 3 coincide with the conditions of area mask 4 in the first embodiment(see Fig.9(a)).

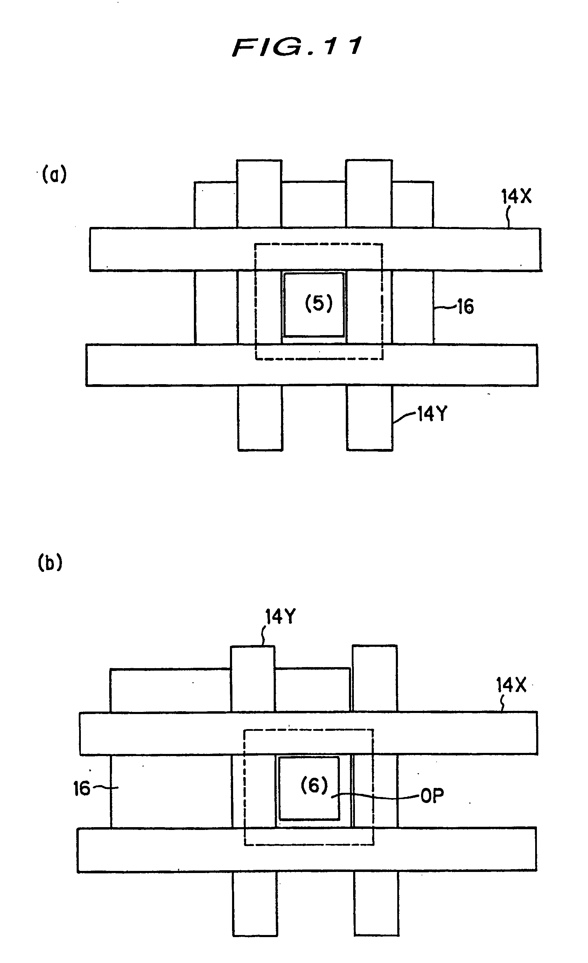

For the case of exposure (2) in Fig.8, since the wiring pattern 3a is located with its three sides adjoining to neighboring patterns, the size of opening OP and its relative position to glass mask 3 are controlled so that margins having a width S1 is formed along the three sides while a margin having a greater width W is formed along the remaining one side (see Fig.9(b)). For the case of exposure (5) of Fig.8, a similar adjustment is performed (see Fig.11(a)).

Here, since there is no identification marking for wiring pattern on the top side as shown in Fig.3(a), needless to say, all the margins may be formed with a width S1 for exposure (2) of Fig.8.

On the other hand, by exposure (5) of Fig.8, identification marking 3c2 can be displayed at the bottom margin.

As described heretofore, use of area mask 10 with its size and position of opening OP adjustable makes it possible to provide an all-purpose masking which, in addition to the effect of the first embodiment, is able to deal with any wiring pattern size, wiring pattern geometry, positions of identification markings and other various conditions. Further, since wide margins can be formed along the periphery of printed board substrate 16, it is possible to secure the plating lead space (for the holding portion during plating) on printed board substrate 16 so improve the plating process efficiency.

The above embodiments have been described with reference to preferred examples of the present invention, but the present invention should not of course be limited to this.

For example, area mask 4 in the first embodiment and movable masks 14X and 14Y in the second embodiment are used to mask the irradiation of light emitted from light source 6 to grass mark 30 at arbitrary positions. However, as another masking means, a liquid crystal panel may be used in which black and white areas can be controlled so as to create arbitrary irradiation areas, which can produce the same operational effects as in the above embodiments.

When a liquid crystal panel equal in size to the printed board substrate is used, it is no longer necessary to shift any part every stepwise exposure, so it is possible to simplify the apparatus and reduce the cost.

In the above embodiments, exposure of identification markings in the spacing between adjacent wiring patterns is avoided so as to improve the production yield. However, if there arise spacings for identification markings being able to be exposed between adjacent wiring patterns because of the optimal number of wiring patterns depending on the shapes of the printed board substrate and wiring patterns or layout geometry, it is of course possible to expose identification markings selectively or regularly in such areas.

As has been described heretofore, according to the first aspect of the present invention, since the masking element selectively masks the identification marking area of the original mask, it is possible to expose the wiring patterns with a narrow spacing therebetween to the printed board substrate, so that the number of wiring patterns to be exposed in a predetermined size can be increased, leading to improvement in production yield and productivity.

It is possible to provide identification markings necessary for production process management by selectively exposing the identification marking area in the area around the periphery of the printed board where no improvement in production yield can be expected or in the spacings between adjoining wiring patterns where no improvement in production yield is expected even when the spacing between the adjacent wiring patterns is made narrow. Further, since wide margins can be formed at the areas close to the periphery of the printed board substrate, it is possible to secure the plating lead space for the printed board substrate, so improve the plating process efficiency.

According to the second aspect of the present invention, since the masking plate is able to selectively mask the identification marking area on the original mask in association with the exposed position on the printed board substrate, it is possible to configure a masking element as a simple device.

According to the third aspect of the present invention, since the masking element is configured of the liquid crystal panel, the identification marking area on the original mask can be selectively masked by electrically switching the black and white areas in the liquid crystal panel without using any mechanically moving part. Further, since the liquid crystal panel has a thin outer dimension and is light-weighted, it is possible to provide a compact printed board manufacturing apparatus.

According to the fourth aspect of the present invention, since a plurality of exposures are performed by masking the identification marking area so that no identification marking area will be exposed between adjacent wiring patterns to be exposed, the spacing between adjacent wiring patterns to be exposed can be controlled so that it is possible to optimally expose as many wiring patterns as possible in a printed board substrate of a predetermined size.

Further, the identification marking area is exposed at the peripheral part of the printed board substrate while areas of wiring patterns are put adjacent to each other.

Accordingly, it is possible to improve the production yield and productivity for a printed board substrate of a predetermined size as well as to provide the identification marking necessary for production process management.

According to the fifth aspect of the present invention, since exposure of wiring patterns on the printed board substrate is sequentially performed stepwise, it is possible to create high-precision wiring patterns by suppressing influences such as thermal contraction of the printed board substrate and the original mask to a high degree.

Since it is possible to expose the identification marking area at the peripheral part of the printed board substrate, it is possible to create the identification marking necessary for production process management. Since wide margins can be formed at the peripheral part and the like of the printed board substrate, it is possible to secure the plating lead space for the printed board substrate, so improve the plating process efficiency.

### Industrial Applicability

As described heretofore, the present invention is suitable for a printed board manufacturing apparatus, printed board manufacturing method and printed boards manufactured by the manufacturing method wherein in the production process of printed wiring boards, a small original photomask is scanned so as to expose a large-sized work by stepwise exposure in which a plurality of exposures are performed sequentially one by one.

## Claims

1. A printed board manufacturing apparatus wherein, in the exposure step for a printed board substrate, the printed board substrate is exposed stepwise a plurality of times through an original mask having a wiring pattern area and an identification marking area around the wiring pattern area while shifting successively one after another position to be exposed, **characterized in that**
the original mask is arranged to face the printed board substrate surface to be exposed;
an opaque masking element is disposed on one side of the original mark on the other side of which disposed is the printed board substrate; and
the opaque masking element selectively masks the identification marking area of the original mask.

2. The printed board manufacturing apparatus according to Claim 1, wherein the masking element is a masking plate which is able to selectively mask the identification marking area on the original mask in association with the position to be exposed of the printed board substrate.

3. The printed board manufacturing apparatus according to Claim 1, wherein the masking element is configured of a liquid crystal panel which is able to selectively mask the identification marking area on the original mask in association with the position to be exposed of the printed board substrate.

4. A printed board manufacturing method wherein, in the exposure step for a printed board substrate, the printed board substrate is exposed stepwise a plurality of times through an original mask having a wiring pattern area and an identification marking area around the wiring pattern area while shifting successively one after another position to be exposed, **characterized in that** a plurality of exposures are performed by masking the identification marking area so that no identification making area will be exposed between adjacent wiring pattern areas to be exposed.

5. A printed board produced by the printed board manufacturing method according to Claim 4.
